# EUROPEAN PATENT APPLICATION

(11) **EP 1 298 969 A1**
(43) Date of publication of application: **02.04.2003**
(21) Application number: 01308207.8
(22) Date of filing: 27.09.2001
(51) Int. Cl.: H05K 1/18, G02B 6/42

(54) **Base member for mounting high-frequency components**

(71) Applicant: Agilent Technologies, Inc. (a Delaware corporation), Palo Alto, CA 94303 (US)
(72) Inventor: Benedelli, Giampaolo, 10040 Almese (TO) (IT); Di Mascio, Enrico, 67039 Sulmona (AQ) (IT); Gastaldi, Luigi, Fiano (TO) (IT); Scofet, Marco, 10086 Rivarolo C.se (TO); Smith, Ian, Woodbridge, Suffolk IP12 4ND (GB)
(74) Representative: Coker, David Graeme

(57) **Abstract**

A support member for high-frequency components (3 to 6) has a generally flat upper surface (2a) provided with a channel or trench-like formation (8; 8a, 8b) therein defining at least one portion of said support member (2) which is recessed with respect to the upper surface (2a). The channel or trench-like formation (8) is thus adapted for receiving at least one thicker component (3 to 5) such as an optical bench (SiOB) or a TIA block while minimizing the length of the wirebonding associated therewith.

## Description

The present invention relates to base or support members for mounting high-frequency electronic components.

A standard arrangement adopted for mounting electronic components such as integrated circuits (IC's) is to provide a flat base member or board having electrical connections provided on at least one of its surfaces in the form of metallic strips or pads. The components are connected to such strips/pads by resorting to various techniques. These may include providing the components with leads or pins to be soldered to such conductive strips/pads or more sophisticated solutions such as "flip-chip" bonding and the like.

As the physical size of the components - and, more to the point, the "height" of the respective packages over the general plane of the mounting board - may vary, the lengths of the electrical interconnections (i.e. the so-called wirebonding) to the strips/pads on the board may correspondingly increase.

This fact does not generally represent a source of concern for low to relatively-high frequency operation.

Conversely, when operation at very high frequencies (in the range of 10 Gbit/s and above) is considered, possibly involving the use of both electrical and optoelectronic components, the need is strongly felt of reducing inasmuch as possible the wirebonding lengths, while also simplifying the geometry of connections provided at the support member/board level.

The object of the present invention is to provide a solution satisfying such a need.

According to the present invention, that object is achieved by means of a support member having the features set forth in the annexed claims.

Essentially, the invention provides a support or base member for e.g. optoelectronic components such as those included in a high bit-rate optical transmission system, having different level heights in order to minimize the wirebonding connections both on the DC and the signal paths.

The support member of the invention is capable of accommodating in a single package the PIN diode, the TIA and limiting amplifier, the so-called optical bench (SiOB) as well as the passive electrical components (bypass and de-coupling capacitors, biasing resistors, etc.) generally included e.g. in an optical receiver package.

The support member of the invention provides different level heights in order to compensate for different thicknesses of various components such as passive components and IC's. The solution of the invention therefore minimizes the lengths of electrical interconnections both on the DC and the signal paths.

For instance, a simple two-level configuration may be adopted, wherein the higher level accommodates the filter capacitors and the lower level is reserved for the SiOB, TIA and DC-blocks and the post amplifier. More complex designs can be devised including e.g. three levels, wherein the highest level is reserved for filter capacitors and the post-amplifier, the intermediate level for DC-blocks and the lowest level for the SiOB and TIA blocks.

The base member of the invention can be manufactured by using any dielectric material adapted for (very) high frequency operation such as alumina. Such a base material can be fabricated by resorting to a layered structure i.e. a superposition of layers, which permits an easy implementation of different heights in the levels by selective local removal of layers.

The invention will now be described, by way of the example only, by referring to the enclosed drawings, wherein:
- figure 1 is a general perspective view of an optical receiver package including a support member according to the invention,
- figure 2 is a general view of a printed or hybrid circuit board including a support member according to the invention, and
- figure 3 is a cross-sectional view of a support member according to an alternative embodiment of the invention.

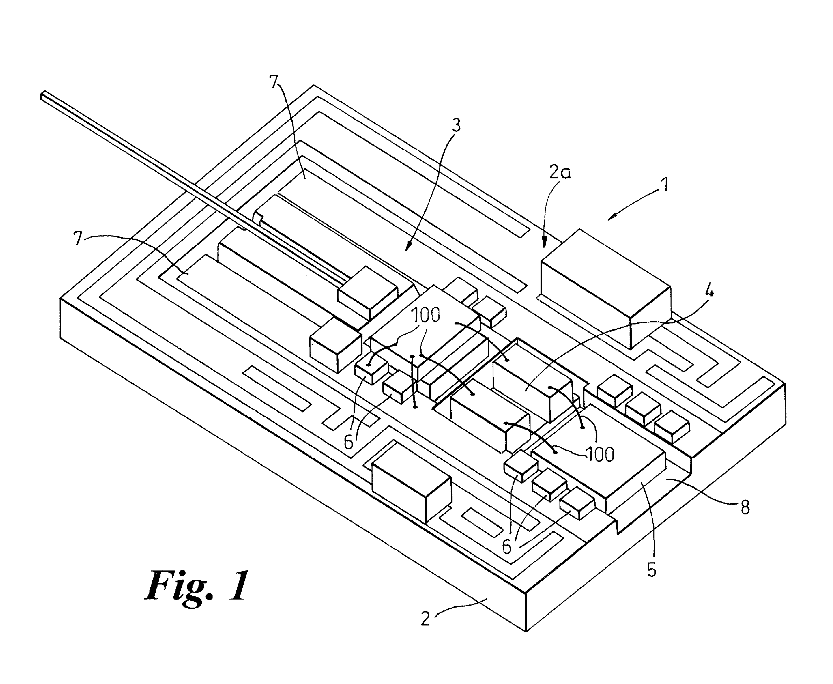

In figure 1, reference numeral 1 designates overall an optical receiver assembly including a plurality of electrical/opto-electronic components arranged on a base or support member or board 2.

In the exemplary embodiment shown herein, the components in question essentially include:
- a SiOB + TIA block 3,
- one or more DC-blocks 4,
- a post-amplifier block 5, and
- a plurality of bypass capacitors 6.

Obviously, referring to an optical receiver assembly including the components/blocks referred to in the foregoing is for exemplary purposes only, in that the invention is applicable to any kinds of components intended for (very) high frequency operation.

The SiOB + TIA and DC blocks 3 and 4 here considered are intended to be exemplary of blocks/components which are relatively "thick" (i.e. exhibit a greater "height" with respect to the general plane of support member 2) with respect to bypass capacitors 6, which are relatively "thin".

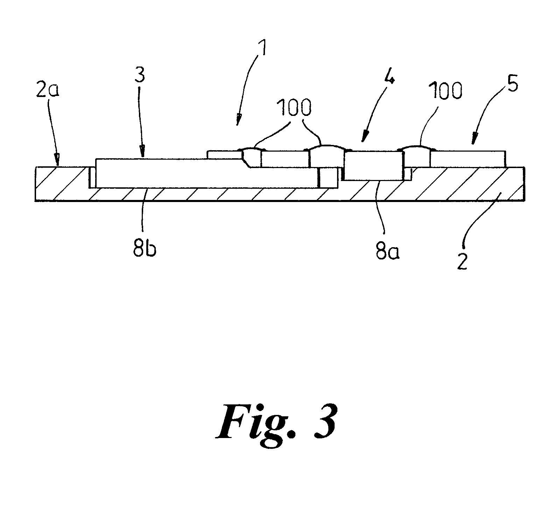

The various components considered are intended to be connected (by standard techniques) among them and/or to connecting layers or strips designated 7 provided at the upper surface of support member 2. Some examples of such component-to-component or component-to-strip connections (wirebonding) are shown at 100 in figures 1 and 3. Obviously this representation is for exemplary purposes only and does not exhaust the wide possibility of such connections likely to be present in an assembly such as assembly 1 shown herein.

Now, if the "thicker" blocks 3 and 4 were to rest on upper surface 2a of support 2 at the same level where post amplifier 5 and capacitors 6 are arranged, the respective wirebonding connections would inevitably turn out to be relatively "long". This would be a source of a number of disadvantages primarily related to undesired effects at very frequency operation.

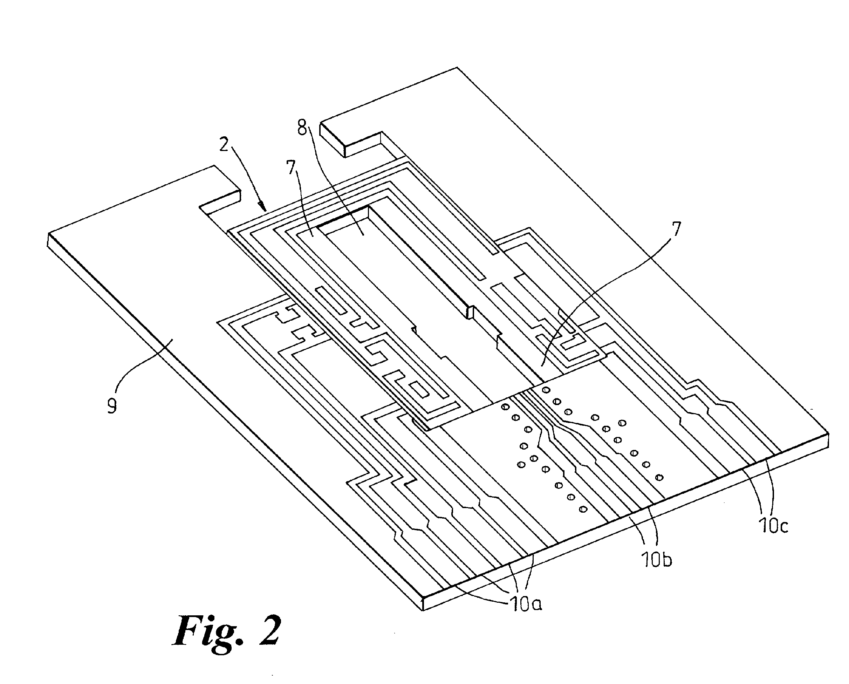

In the arrangement of the invention upper surface 2a of support member 2 is not entirely flat. More specifically, in the arrangement of the invention, such upper surface exhibits at least two different levels. The first level is represented by upper surface 2a itself, where connecting layers or strips 7 are located. A second, deeper level is represented by the bottom surface of a channel-like or trench formation 8 provided in support member 2 as better shown in figure 2.

The "thicker" blocks 3 and 4 (and, possibly, post amplifier 5 - which has a thickness intermediate the thickness of the SiOB+TIA plus DC blocks 3 and 4 and the thickness of bypass capacitors 6) are thus accommodated in channel-like formation 8 as shown in figure 1. This enables such thicker blocks to be connected to e.g. layers or strips 7 by means of wirebonding connections which are relatively short as these connections no longer have to allow for the greater thicknesses or heights of the respective blocks 3 and 4.

In the arrangement of the invention such greater thickness or height is in fact allowed for by causing blocks 3 and 4 to be so-to-say deep-set or sunken into channel or trench formation 8 provided in support member 2.

Support member 2 can be of any dielectric material adapted for high frequency operation and is preferably comprised of layered alumina. Selective removal of the portion(s) of those layers corresponding to formation 8 permits such a formation to be easily provided by resorting to standard printed or hybrid circuit technology.

Figure 2 shows support member 2 (with components 3 to 6 removed for clarity of illustration) in its final possible location within an opening provided in larger outer connection board 9 showing strip-like contacts 10a, 10b and 10c for insertion in a package (non shown).

Figure 3 shows an alternative embodiment of the invention wherein three different levels are provided for mounting components onto support member 2. In embodiment of figure 3 two recessed formations, designated 8a and 8b respectively, are provided substantially corresponding to formation 8 of figure 1 and having two different levels of thickness, formation 8b being thus generally "deeper" than formation 8a.

Deeper channel formation 8b is intended to house the SiOB + TIA blocks 3 while the intermediate level defined by formation 8a is intended to house DC blocks 4. Finally the upper level, generally corresponding to the upper surface of support member 2, is intended to support capacitors 6 (and possibly post-amplifier block 5).

Of course, the basic principle of the invention remaining the same, the details and the embodiments may vary with respect to the exemplary embodiments shown and described in the foregoing without departing from the scope of the invention as defined in the annexed claims.

## Claims

1. A support member for electronic components having a generally flat surface (2a) for supporting at least one first component (2 to 5) and at least one second component (6), said at least one first component and said at least one second component being relatively thicker and thinner, **characterized in that** it includes at least one channel or trench-like formation (8; 8a, 8b) defining at least one portion of said support member (2) which is recessed with respect to said surface (2a), said channel or trench-like formation being adapted for receiving said at least one first, thicker component (2 to 5).

2. The support member of claim 1,
**characterized in that** said channel or trench-like formation includes at least two portions (8a, 8b) having different depths with respect to said surface (2a).

3. A support member of either of claims 1 or 2, **characterized in that** said member (2) is comprised of a dielectric material.

4. The support member of claim 3,
**characterized in that** said support member (2) is comprised of a dielectric material adapted for high frequency operation.

5. The support member of either of claims 3 or 4, **characterized in that** said dielectric material is alumina.

6. The support member of any of the previous claims, **characterized in that** said support member is comprised of a layered material, whereby said channel or trench-like formation (8; 8a, 8b) is defined by at least one layer selectively removed from said layered structure.

7. The support member of any of the previous claims, **characterized in that** it has associated therewith said at least second component in the form of a capacitor (6) mounted on said surface (2a).

8. The support member of any of the previous claims, **characterized in that** it has associated therewith said at least one first component, said at least one first component being selected out of the group consisting of:
- an optical bench (SiOB),
- a TIA block (3)
- a DC block (4), and
- a post-amplifier (5) for an optical receiver package.

9. The support member of claim 2
**characterized in that** it has associated therewith a first set and a second set of said first components, wherein said at least one first set includes at least one component selected from the group consisting of an optical bench (SiOB) and a TIA block arranged in a first one (8b) of said at least two portions of said channel or trench-like formation and said second set includes a DC-block (4) arranged in another (8a) of said at least two portions of said channel or trench-like formation (8).

10. The support member of claim 9,
**characterized in that** it includes a post-amplifier (5) for an optical receiver package mounted at said upper surface (2a).
